# FASCICULE DE BREVET EUROPEEN

(11) **EP 3 288 054 B1**
(45) Date de publication et mention de la délivrance du brevet: **13.03.2019**
(21) Numéro de dépôt: 17187756.6
(22) Date de dépôt: 24.08.2017
(51) Int. Cl.: H01H 9/14, E04F 10/06, H05K 1/02, H02K 11/40

(54) **ACTIONNEUR ÉLECTROMÉCANIQUE TUBULAIRE ET INSTALLATION DOMOTIQUE COMPRENANT UN TEL ACTIONNEUR**
RÖHRENFÖRMIGER ELEKTROMECHANISCHER AKTOR UND HEIMAUTOMATISIERUNGSINSTALLATION UMFASSEND EINEN DERARTIGEN AKTOR
TUBULAR ELECTROMECHANICAL ACTUATOR AND HOME-AUTOMATION INSTALLATION COMPRISING SUCH AN ACTUATOR

(30) Priorité: 26.08.2016 FR 1657979
(43) Date de publication de la demande: 28.02.2018
(73) Titulaire: SOMFY ACTIVITES SA, 74300 Cluses (FR)
(72) Inventeur: TERRIER, Nicolas, 69008 LYON (FR); SOULET, Arnaud, 38660 Lumbin (FR); BURDET, Lionel, 74350 Cuvat (FR); RIFFAUD, Stéphane, 74700 Sallanches (FR)
(74) Mandataire: Lavoix

(56) Documents cités:
- EP-A1- 2 857 608
- EP-A2- 1 767 740
- DE-A1-102010 025 887
- DE-U1-202006 010 814
- US-A1- 2006 266 544
- US-A1- 2012 026 639
- US-A1- 2015 098 192
- US-A1- 2015 333 510

## Description

La présente invention concerne un actionneur électromécanique tubulaire.

La présente invention concerne également une installation domotique de protection solaire comprenant un écran enroulable sur un tube d'enroulement entraîné en rotation par un tel actionneur électromécanique tubulaire.

De manière générale, la présente invention concerne le domaine des dispositifs d'occultation comprenant un dispositif d'entraînement motorisé mettant en mouvement un écran, entre au moins une première position et au moins une deuxième position.

Un dispositif d'entraînement motorisé comprend un actionneur électromécanique d'un élément mobile de protection solaire, tel qu'un store, un volet roulant ou tout autre matériel équivalent, appelé par la suite écran.

On connaît déjà des actionneurs électromécaniques tubulaires pour une installation domotique de protection solaire, en particulier d'un store enroulable. L'actionneur du store enroulable comprend un carter, un moteur électrique, une unité électronique de contrôle et un dispositif de décharge de charges électrostatiques. Le moteur électrique est alimenté en énergie électrique au moyen de conducteurs électriques. Les conducteurs électriques sont configurés pour être reliés électriquement à un réseau d'alimentation en énergie électrique. L'unité électronique de contrôle comprend une plaquette de circuit imprimé équipée de composants électroniques.

Dans de telles installations domotiques de protection solaire, des charges électrostatiques sont générées par le frottement de la toile du store enroulable sur une partie en matière plastique ou métallique du store.

Les actionneurs connus sont dits de classe de protection électrique 1, c'est-à-dire que ceux-ci présentent une isolation électrique réalisée au moyen d'une prise de terre sur laquelle sont reliées électriquement les parties métalliques.

De tels actionneurs sont ainsi reliés électriquement à une terre, au moyen d'un conducteur électrique de terre relié électriquement au carter de l'actionneur réalisé dans un matériau métallique, permettant d'évacuer des charges électrostatiques.

Cependant ces actionneurs, dits de classe de protection électrique 1, présentent l'inconvénient de ne mettre en oeuvre qu'une simple isolation électrique engendrant une augmentation des coûts d'obtention de ceux-ci, due à la liaison électrique entre le carter de l'actionneur et un conducteur électrique de terre.

En outre, le carter de l'actionneur électromécanique est réalisé dans un matériau qui est nécessairement conducteur du point de vue électrique, pour évacuer les charges électrostatiques.

Par ailleurs, dans le cas où des actionneurs dits de classe de protection électrique 2 peuvent être utilisés dans des installations domotiques de protection solaire, ceux-ci ne sont pas reliés électriquement à une terre, c'est-à-dire que ceux-ci présentent une isolation électrique renforcée sans partie métallique accessible.

Cependant ces actionneurs, dits de classe de protection électrique 2, présentent l'inconvénient d'évacuer des charges électrostatiques au travers de la plaquette de circuit imprimé de l'unité électronique de contrôle de l'actionneur, puis au travers du réseau d'alimentation en énergie électrique.

Par conséquent, l'évacuation de charges électrostatiques au travers de la plaquette de circuit imprimé provoque des dysfonctionnements de ces actionneurs et/ou des endommagements de ceux-ci, notamment par la destruction de composants électroniques.

Les classes de protection électrique des actionneurs sont, notamment, définies par la norme CEI 60-335-1 et 2.

On connaît également le document US 2015/0333510 A1 qui décrit un actionneur électromécanique tubulaire pour une installation domotique de protection solaire comprenant une enveloppe, un moteur électrique, une unité électronique de contrôle et un dispositif de décharge de charges électrostatiques. Le moteur électrique est alimenté en énergie électrique au moyen de batteries. L'unité électronique de contrôle comprend une plaquette de circuit imprimé équipée de composants électroniques. Le dispositif de décharge de charges électrostatiques est disposé sur une ligne d'entrée entre une antenne et d'autres composants de la plaquette de circuit imprimé, en particulier un récepteur. Le dispositif de décharge de charges électrostatiques comprend deux diodes antiparallèles et un inducteur pour évacuer la charge électrostatique vers une masse.

La présente invention a pour but de résoudre les inconvénients précités et de proposer un actionneur électromécanique tubulaire, ainsi qu'une installation domotique de protection solaire comprenant un tel actionneur, permettant d'éviter l'évacuation de charges électrostatiques au travers de composants électroniques d'une plaquette de circuit imprimé d'une unité électronique de contrôle de l'actionneur, de sorte à garantir la fiabilité de fonctionnement de l'actionneur et à empêcher la destruction des composants électroniques.

A cet effet, la présente invention vise, selon un premier aspect, un actionneur électromécanique tubulaire pour une installation domotique de protection solaire comprenant :
- une enveloppe conductrice,
- un moteur électrique, le moteur électrique étant alimenté en énergie électrique au moyen de conducteurs électriques, les conducteurs électriques étant configurés pour être reliés électriquement à un réseau d'alimentation en énergie électrique,
- une unité électronique de contrôle, l'unité électronique de contrôle comprenant une plaquette de circuit imprimé équipée de composants électroniques,
- un dispositif de décharge de charges électrostatiques.

Selon l'invention, le dispositif de décharge de charges électrostatiques comprend un éclateur ménagé au niveau de la plaquette de circuit imprimé de l'unité électronique de contrôle, l'éclateur comprenant une première et une deuxième électrodes formées respectivement par une première piste conductrice et par une deuxième piste conductrice de la plaquette de circuit imprimé, la première électrode étant reliée électriquement à l'enveloppe conductrice de l'actionneur et la deuxième électrode étant reliée électriquement à l'un des conducteurs électriques d'alimentation en énergie électrique du moteur électrique.

Ainsi, l'évacuation de charges électrostatiques au travers de l'éclateur ménagé au niveau de la plaquette de circuit imprimé de l'unité électronique de contrôle de l'actionneur permet de créer un chemin préférentiel et maîtrisé de décharge entre l'enveloppe conductrice de l'actionneur et l'un des conducteurs électriques d'alimentation en énergie électrique du moteur électrique de l'actionneur.

De cette manière, l'évacuation de charges électrostatiques au travers de l'éclateur ménagé au niveau de la plaquette de circuit imprimé permet d'éviter des dysfonctionnements et/ou des endommagements de l'actionneur et, en particulier, d'empêcher la destruction de composants électroniques montés sur la plaquette de circuit imprimé.

Par conséquent, l'éclateur ménagé au niveau de la plaquette de circuit imprimé permet d'évacuer des charges électrostatiques accumulées dans un écran d'un dispositif d'occultation de l'installation domotique de protection solaire.

De cette manière, l'éclateur ménagé au niveau de la plaquette de circuit imprimé permet de protéger l'unité électronique de contrôle de l'actionneur.

En outre, l'éclateur permet de limiter les surtensions au niveau des composants électroniques montés sur la plaquette de circuit imprimé et de réaliser des courts-circuits par un arc électrique, lors de la décharge des charges électrostatiques, de sorte à protéger l'unité électronique de contrôle de l'actionneur.

Selon une caractéristique préférée de l'invention, le conducteur électrique d'alimentation en énergie électrique du moteur électrique relié électriquement à la deuxième électrode de l'éclateur est un conducteur électrique de neutre ou de phase, le conducteur électrique d'alimentation en énergie électrique du moteur électrique étant configuré pour être relié électriquement à un conducteur électrique du réseau d'alimentation en énergie électrique.

Selon une caractéristique avantageuse de l'invention, une première extrémité de la première électrode de l'éclateur est disposée en vis-à-vis d'une première extrémité de la deuxième électrode de l'éclateur, la première extrémité de la première électrode étant distante de la première extrémité de la deuxième électrode d'un écartement déterminé.

Selon une autre caractéristique avantageuse de l'invention, la première extrémité de chacune des première et deuxième électrodes de l'éclateur est en forme de pointe.

Selon une autre caractéristique avantageuse de l'invention, la première extrémité de la première électrode est séparée de la première extrémité de la deuxième électrode par un trou ménagé dans la plaquette de circuit imprimé.

Selon une autre caractéristique avantageuse de l'invention, l'enveloppe conductrice de l'actionneur électromécanique est reliée électriquement à une masse de référence.

Avantageusement, l'actionneur électromécanique comprend un câble d'alimentation électrique. Le câble d'alimentation électrique comprend une pluralité de conducteurs électriques. Et les conducteurs électriques d'alimentation en énergie électrique du moteur électrique sont reliés électriquement aux conducteurs électriques du câble d'alimentation électrique.

Dans un mode de réalisation, l'enveloppe conductrice de l'actionneur est un carter de l'actionneur réalisé dans un matériau métallique, à l'intérieur duquel est logée l'unité électronique de contrôle.

Dans un autre mode de réalisation, l'enveloppe conductrice de l'actionneur est réalisée au moyen d'une couche conductrice ménagée sur une surface interne d'un carter de l'actionneur.

La présente invention vise, selon un deuxième aspect, une installation domotique de protection solaire comprenant un écran enroulable sur un tube d'enroulement entraîné en rotation par un actionneur électromécanique tubulaire conforme à l'invention.

Cette installation domotique présente des caractéristiques et avantages analogues à ceux décrits précédemment en relation avec l'actionneur électromécanique tubulaire selon l'invention, tel que mentionné ci-dessus.

D'autres particularités et avantages de l'invention apparaîtront encore dans la description ci-après.

Aux dessins annexés, donnés à titre d'exemples non limitatifs :
- la figure 1 est une vue schématique en perspective d'une installation domotique conforme à un mode de réalisation de l'invention ;
- la figure 2 est une vue schématique en perspective de l'installation domotique illustrée à la figure 1, où un coffre d'un dispositif d'occultation a été ôté et où un écran est représenté en partie transparent ;
- la figure 3 est une vue schématique en coupe partielle et longitudinale de l'installation domotique illustrée aux figures 1 et 2 ;
- la figure 4 est une vue schématique en coupe partielle et longitudinale d'un actionneur électromécanique illustré à la figure 3 ;
- la figure 5 est un schéma électrique simplifié d'une partie d'une unité électronique de contrôle de l'actionneur électromécanique illustré aux figures 3 et 4 ; et
- la figure 6 est une vue schématique d'un éclateur réalisé sur une plaquette de circuit imprimé de l'unité électronique de contrôle de l'actionneur électromécanique illustrée à la figure 5.

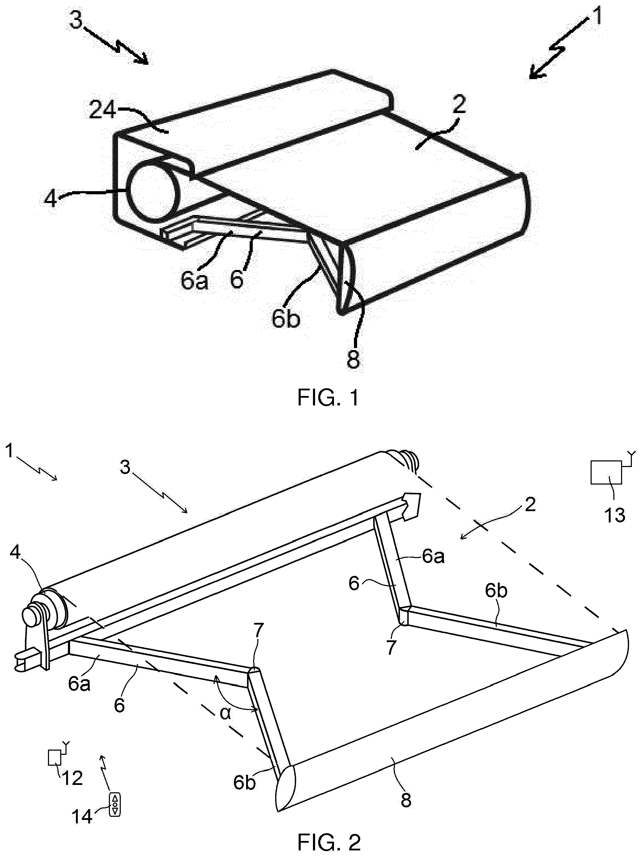

On décrit tout d'abord, en référence aux figures 1 à 3, une installation domotique 1 conforme à l'invention et installée sur un bâtiment, non représenté, équipé d'un écran 2 appartenant à un dispositif d'occultation 3, en particulier un store à bras motorisé.

Le dispositif d'occultation 3 peut, avantageusement, être disposé au-dessus d'une terrasse.

On décrit, en référence aux figures 1 et 2, un store à bras conforme à un mode de réalisation de l'invention.

L'écran 2 du dispositif d'occultation 3 est enroulé sur un tube d'enroulement 4 entraîné par un dispositif d'entraînement motorisé 5 et mobile entre une position enroulée, en particulier haute, et une position déroulée, en particulier basse.

L'écran 2 mobile du dispositif d'occultation 3 est un écran de protection solaire, s'enroulant sur le tube d'enroulement 4 dont le diamètre intérieur est sensiblement supérieur au diamètre externe d'un actionneur électromécanique 11, de sorte que l'actionneur électromécanique 11 puisse être inséré dans le tube d'enroulement 4, lors de l'assemblage du dispositif d'occultation 3.

Le dispositif d'entraînement motorisé 5 comprend l'actionneur électromécanique 11, en particulier de type tubulaire, permettant de mettre en rotation le tube d'enroulement 4, de sorte à dérouler ou enrouler l'écran 2 du dispositif d'occultation 3.

Le dispositif d'occultation 3 comprend le tube d'enroulement 4 pour enrouler l'écran 2, où, dans l'état monté, l'actionneur électromécanique 11 est inséré dans le tube d'enroulement 4.

L'actionneur électromécanique 11 permet de déplacer l'écran 2 du dispositif d'occultation 3.

Le dispositif d'occultation 3 comprend également une barre 8 et deux bras 6.

En variante, le dispositif d'occultation 3 peut comprendre un nombre de bras 6 supérieur à deux, en particulier en fonction des dimensions de l'écran 2.

Les bras 6 du dispositif d'occultation 3 sont articulés et, plus particulièrement, configurés pour être pliés ou dépliés en fonction de l'enroulement ou du déroulement de l'écran 2.

Chaque bras 6 du dispositif d'occultation 3 comprend deux segments de bras 6a, 6b. Une extrémité d'un premier segment de bras 6a est reliée à une extrémité d'un deuxième segment de bras 6b par l'intermédiaire d'une articulation 7.

De cette manière, l'articulation 7 de chaque bras 6 est disposée entre les deux segments de bras 6a, 6b et, avantageusement, en partie centrale, de sorte à permettre un pivotement des deux segments de bras 6a, 6b l'un par rapport à l'autre autour d'un axe de rotation. L'angle défini entre les deux segments de bras 6a, 6b est noté α.

De manière connue, le store à bras, qui forme le dispositif d'occultation 3, comporte une toile, formant l'écran 2 du store enroulable 3. Une première extrémité de l'écran 2, en particulier l'extrémité supérieure de l'écran 2 dans la configuration assemblée du dispositif d'occultation 3 dans l'installation domotique 1, est fixée au tube d'enroulement 4. Par ailleurs, une deuxième extrémité de l'écran 2, en particulier l'extrémité inférieure de l'écran 2 dans la configuration assemblée du dispositif d'occultation 3 dans l'installation domotique 1, est fixée à la barre 8.

En outre, une première extrémité de chacun des bras 6, en particulier l'extrémité supérieure de chacun des bras 6 dans la configuration assemblée du dispositif d'occultation 3 dans l'installation domotique 1, est fixée à une structure porteuse du dispositif d'occultation 3. En outre, une deuxième extrémité de chacun des bras 6, en particulier l'extrémité inférieure de chacun des bras 6 dans la configuration assemblée du dispositif d'occultation 3 dans l'installation domotique 1, est fixée à la barre 8.

La structure porteuse est configurée pour être fixée sur un mur du bâtiment, en particulier par des éléments de fixation par vissage, non représentés.

La structure porteuse peut être réalisée au moyen d'un coffre 24 et/ou de supports disposés respectivement à chaque extrémité du tube d'enroulement 4.

Chaque bras 6 comprend un ressort, non représenté, de sorte que l'écran 2 se déploie sous l'effet des ressorts. Le ressort de chaque bras 6 est comprimé, lorsque les bras 6 sont en position repliée.

Chaque bras 6 comprend également un mécanisme de butée, non représenté, pouvant être réglable. Ce mécanisme de butée d'un bras 6 permet de délimiter la course angulaire maximale de déplacement du premier segment de bras 6a par rapport au deuxième segment de bras 6b. La valeur de la course angulaire maximale de déplacement du premier segment de bras 6a par rapport au deuxième segment de bras 6b est avantageusement inférieure à 180° et préférentiellement inférieure à 150°.

Ici, la toile formant l'écran 2 est réalisée à partir d'un matériau textile. Par ailleurs, une telle toile formant l'écran 2 est prévue pour être imperméable à l'eau et à l'air, autrement dit résistante à la pluie et au vent.

Dans un exemple de réalisation non représenté, la première extrémité de l'écran 2 présente un ourlet au travers duquel est disposée une tige, en particulier en matière plastique. Cet ourlet réalisé au niveau de la première extrémité de l'écran 2 est obtenu au moyen d'une couture de la toile formant l'écran 2. Lors de l'assemblage de l'écran 2 sur le tube d'enroulement 4, l'ourlet et la tige situés au niveau de la première extrémité de l'écran 2 sont insérés par coulissement dans une rainure ménagée sur la face externe du tube d'enroulement 4, en particulier sur toute la longueur du tube d'enroulement 4, de sorte à pouvoir enrouler et dérouler l'écran 2 autour du tube d'enroulement 4.

Dans le cas d'un store à bras, la position enroulée correspond à la mise en appui de la barre 8 contre un bord d'un coffre 24 du store à bras 3, et la position déroulée correspond à une position précédent le cassage des bras 6, dans laquelle l'écran 2 est tendu.

Ici, le tube d'enroulement 4 est disposé à l'intérieur du coffre 24 du store enroulable 3. L'écran 2 du store enroulable 3 s'enroule et se déroule autour du tube d'enroulement 4 et est logé au moins en partie à l'intérieur du coffre 24.

De manière générale, le coffre 24 est disposé au-dessus d'une ouverture, non représentée, ménagée dans le bâtiment.

Le dispositif d'entraînement motorisé 5 est commandé par une unité de commande. L'unité de commande peut être, par exemple, une unité de commande locale 12, où l'unité de commande locale 12 peut être reliée en liaison filaire ou non filaire avec une unité de commande centrale 13. L'unité de commande centrale 13 pilote l'unité de commande locale 12, ainsi que d'autres unités de commande locales similaires et réparties dans le bâtiment.

L'unité de commande centrale 13 peut être en communication avec une station météorologique déportée à l'extérieur du bâtiment, incluant, notamment, un ou plusieurs capteurs pouvant être configurés pour déterminer, par exemple, une température, une luminosité, ou encore une vitesse de vent.

Une télécommande 14, pouvant être un type d'unité de commande locale, et pourvue d'un clavier de commande, qui comprend des éléments de sélection et d'affichage, permet, en outre, à un utilisateur d'intervenir sur l'actionneur électromécanique 11 et/ou l'unité de commande centrale 13.

Le dispositif d'entraînement motorisé 5 est, de préférence, configuré pour exécuter les commandes de déroulement ou d'enroulement de l'écran 2 du dispositif d'occultation 3, pouvant être émises, notamment, par la télécommande 14.

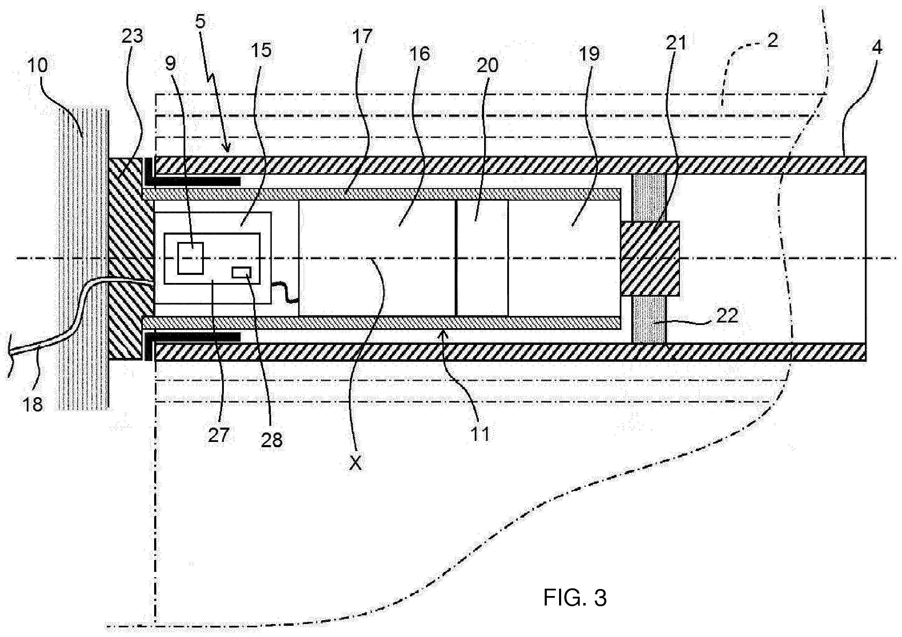

L'actionneur électromécanique 11 comprend un moteur électrique 16. Le moteur électrique 16 comprend un rotor et un stator, non représentés, positionnés de manière coaxiale autour d'un axe de rotation X, qui est également l'axe de rotation du tube d'enroulement 4 en configuration montée du dispositif d'entraînement motorisé 5, comme illustré à la figure 3.

Des moyens de commande de l'actionneur électromécanique 11 conforme à l'invention, permettant le déplacement de l'écran 2 du dispositif d'occultation 3, comprennent au moins une unité électronique de contrôle 15. Cette unité électronique de contrôle 15 est apte à mettre en fonctionnement le moteur électrique 16 de l'actionneur électromécanique 11 et, en particulier, permettre l'alimentation en énergie électrique du moteur électrique 16.

Ainsi, l'unité électronique de contrôle 15 commande, notamment, le moteur électrique 16, de sorte à dérouler ou enrouler l'écran 2, comme décrit précédemment.

L'unité électronique de contrôle 15 comprend également un module de réception d'ordres, en particulier d'ordres radioélectriques émis par un émetteur d'ordres, tel que la télécommande 14 destinée à commander l'actionneur électromécanique 11 ou l'une des unités de commande locale 12 ou centrale 13.

Le module de réception d'ordres peut également permettre la réception d'ordres transmis par des moyens filaires.

Lorsqu'un ordre de déroulement de l'écran 2 est reçu par l'unité électronique de contrôle 15, l'actionneur électromécanique 11 entraîne en rotation le tube d'enroulement 4 dans un premier sens, dit de déploiement de l'écran 2, et libère les bras 6, de sorte à les déplier, en particulier sous l'action des ressorts.

Lorsqu'un ordre d'enroulement de l'écran 2 est reçu par l'unité électronique de contrôle 15, l'actionneur électromécanique 11 entraîne en rotation le tube d'enroulement 4 dans un deuxième sens, dit de repli de l'écran 2, et replie les bras 6, en particulier en comprimant les ressorts.

L'unité électronique de contrôle 15 est configurée pour arrêter automatiquement l'actionneur électromécanique 11, suite à la réception d'un ordre de commande d'arrêt pouvant être émis par l'une des unités de commande 12, 13, 14, ou suite à la détermination de l'atteinte d'une position de fin de course basse, autrement dit de déroulement complet de l'écran 2, ou haute, autrement dit d'enroulement complet de l'écran 2.

Ici, et tel qu'illustré à la figure 3, l'unité électronique de contrôle 15 est disposée à l'intérieur d'un carter 17 de l'actionneur électromécanique 11.

Les moyens de commande de l'actionneur électromécanique 11 comprennent des moyens matériels et/ou logiciels.

A titre d'exemple nullement limitatif, les moyens matériels peuvent comprendre au moins un microcontrôleur.

On décrit à présent, plus en détail et en référence à la figure 3, l'actionneur électromécanique 11 appartenant à l'installation domotique 1 des figures 1 et 2.

L'actionneur électromécanique 11 est alimenté en énergie électrique par un réseau d'alimentation électrique du secteur, en particulier par le réseau alternatif commercial.

La tension du réseau d'alimentation électrique ou tension secteur présente, par exemple, une valeur de 230 VRMS (valeur de crête de 325V) pour le réseau électrique français et une fréquence de 50 Hz.

La tension secteur peut présenter des valeurs différentes, en fonction du réseau électrique du pays dans lequel on se situe.

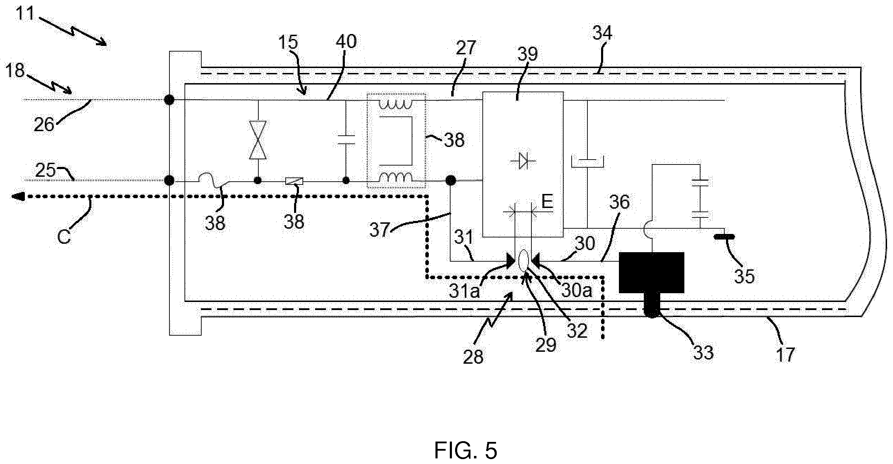

Le moteur électrique 16 de l'actionneur électromécanique 11 est alimenté en énergie électrique au moyen de conducteurs électriques 25, 26, comme illustré à la figure 5.

Ici, l'actionneur électromécanique 11 comprend un câble d'alimentation électrique 18 permettant son alimentation en énergie électrique à partir du réseau d'alimentation électrique du secteur.

Les conducteurs électriques 25, 26 sont configurés pour être reliés électriquement au réseau d'alimentation en énergie électrique, en particulier à travers le câble d'alimentation électrique 18.

Le carter 17 de l'actionneur électromécanique 11 est, préférentiellement, de forme cylindrique.

Ici, le moteur électrique 16 est de type sans balais à commutation électronique, appelé également « BLDC » (acronyme du terme anglo-saxon BrushLess Direct Current) ou « synchrone à aimants permanents ».

L'unité électronique de contrôle 15 de l'actionneur électromécanique 11 comprend un circuit, non représenté, de redressement de la tension alternative du réseau d'alimentation électrique et un module d'alimentation électrique, non représenté. Le module d'alimentation électrique est ainsi connecté électriquement à une source de tension continue +Vbus. La valeur de la tension continue +Vbus est définie par rapport à une tension de référence Gnd.

Le module d'alimentation électrique alimente en énergie électrique, de manière séquentielle, des bobines du moteur électrique 16, de sorte à produire un champ électromagnétique tournant provoquant l'entraînement en rotation du rotor du moteur électrique 16.

Le module d'alimentation électrique comprend des commutateurs permettant de réaliser l'alimentation électrique séquentielle des bobines.

Ici, les commutateurs du module d'alimentation électrique sont des transistors de type « MOSFET » (acronyme du terme anglo-saxon Metal Oxide Semiconductor Field Effect Transistor) et au nombre de six. Le type de commutateurs du module d'alimentation électrique et leur nombre ne sont pas limitatifs. En particulier, les commutateurs du module d'alimentation électrique peuvent être des transistors de type « IGBT » (acronyme du terme anglo-saxon Insulated Gâte Bipolar Transistor).

L'actionneur électromécanique 11 comprend également un dispositif de réduction à engrenages 19, un frein 20 et un arbre de sortie 21.

Avantageusement, le moteur électrique 16, le dispositif de réduction à engrenages 19 et le frein 20 sont disposés à l'intérieur du carter 17 de l'actionneur électromécanique 11.

Le frein 20 de l'actionneur électromécanique 11 est configuré pour bloquer en rotation l'arbre de sortie 21, de sorte à réguler la vitesse de rotation du tube d'enroulement 4, lors d'un déplacement de l'écran 2, et à maintenir bloqué le tube d'enroulement 4, lorsque l'actionneur électromécanique 11 est à l'arrêt.

L'arbre de sortie 21 de l'actionneur électromécanique 11 est disposé à l'intérieur du tube d'enroulement 4, et au moins en partie à l'extérieur du carter 17 de l'actionneur électromécanique 11.

L'arbre de sortie 21 de l'actionneur électromécanique 11 est accouplé par un élément de liaison 22 au tube d'enroulement 4, en particulier un élément de liaison en forme de roue.

L'actionneur électromécanique 11 comprend également un élément d'obturation 23 d'une extrémité du carter 17.

Ici, le carter 17 de l'actionneur électromécanique 11 est fixé à un support 10, en particulier une joue, du coffre 24 du dispositif d'occultation 3 au moyen de l'élément d'obturation 23 formant un support de couple, en particulier une tête d'obturation et de reprise de couple. Dans un tel cas où l'élément d'obturation 23 forme un support de couple, l'élément d'obturation 23 est également appelé un « point fixe » de l'actionneur électromécanique 11.

L'unité électronique de contrôle 15 de l'actionneur électromécanique 11 comprend un dispositif de détection d'obstacle et de fins de course lors de l'enroulement de l'écran 2 et lors du déroulement de cet écran 2.

Le dispositif de détection d'obstacle et de fins de course lors de l'enroulement et lors du déroulement de l'écran 2 est mis en oeuvre au moyen d'un microcontrôleur 9 de l'unité électronique de contrôle 15 et, en particulier, au moyen d'un algorithme mis en oeuvre par ce microcontrôleur 9.

L'unité électronique de contrôle 15 comprend également une plaquette de circuit imprimé 27 équipée de composants électroniques.

L'actionneur électromécanique 11 comprend également un dispositif de décharge de charges électrostatiques 28.

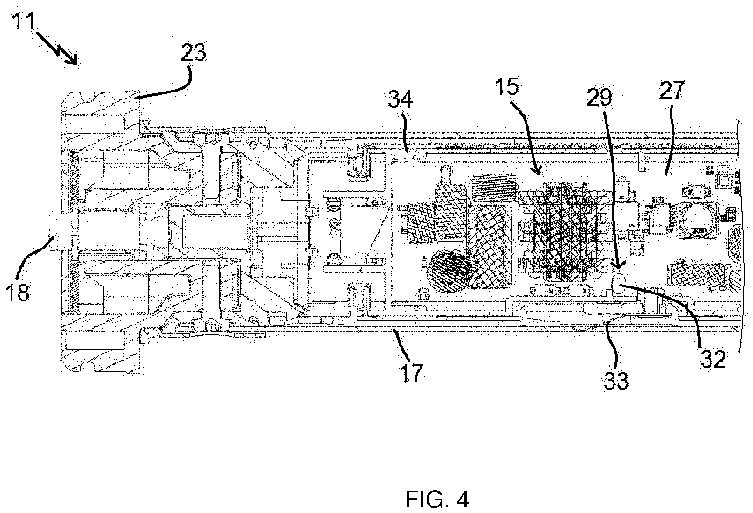

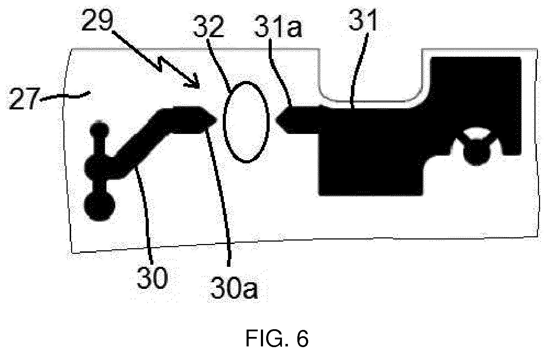

On décrit maintenant, en référence aux figures 4 à 6, l'intégration du dispositif de décharge de charges électrostatiques 28 au niveau de l'actionneur électromécanique tubulaire 11.

Le dispositif de décharge de charges électrostatiques 28 comprend un éclateur 29 ménagé au niveau de la plaquette de circuit imprimé 27 de l'unité électronique de contrôle 15.

L'éclateur 29 comprend une première et une deuxième électrodes 30, 31 formées respectivement par une première piste conductrice 36 et par une deuxième piste conductrice 37 de la plaquette de circuit imprimé 27. La première électrode 30 est reliée électriquement à une enveloppe conductrice 17 de l'actionneur électromécanique 11. Et la deuxième électrode 31 est reliée électriquement à l'un des conducteurs électriques 25, 26 d'alimentation en énergie électrique du moteur électrique 16.

Ainsi, l'évacuation de charges électrostatiques au travers de l'éclateur 29 ménagé au niveau de la plaquette de circuit imprimé 27 de l'unité électronique de contrôle 15 de l'actionneur électromécanique 11 permet de créer un chemin C préférentiel de décharge entre l'enveloppe conductrice 17 de l'actionneur électromécanique 11 et l'un des conducteurs électriques 25, 26 d'alimentation en énergie électrique du moteur électrique 16 de l'actionneur électromécanique 11.

De cette manière, l'évacuation de charges électrostatiques au travers de l'éclateur 29 ménagé au niveau de la plaquette de circuit imprimé 27 permet d'éviter des dysfonctionnements et/ou des endommagements de l'actionneur électromécanique 11 et, en particulier, d'empêcher la destruction de composants électroniques montés sur la plaquette de circuit imprimé 27.

Par conséquent, l'éclateur 29 ménagé au niveau de la plaquette de circuit imprimé 27 permet d'évacuer des charges électrostatiques accumulées dans l'écran 2 du dispositif d'occultation 3 de l'installation domotique 1 de protection solaire.

De cette manière, l'éclateur 29 ménagé au niveau de la plaquette de circuit imprimé 27 permet de protéger l'unité électronique de contrôle 15 de l'actionneur électromécanique 11.

En outre, l'éclateur 29 permet de limiter les surtensions au niveau des composants électroniques montés sur la plaquette de circuit imprimé 27 et de réaliser des courts-circuits par un arc électrique, lors de la décharge des charges électrostatiques, de sorte à protéger l'unité électronique de contrôle 15.

Dans l'exemple de réalisation illustré à la figure 5, la deuxième électrode 31 est reliée électriquement au conducteur électrique 25 d'alimentation en énergie électrique du moteur électrique 16.

Ici et comme illustré à la figure 5, le chemin C préférentiel de décharge est représenté par un trait en pointillés.

Un tel dispositif de décharge de charges électrostatiques 28 réalisé au moyen d'un éclateur 29 au niveau de la plaquette de circuit imprimé 27 de l'unité électronique de contrôle 15 est peu onéreux et permet de minimiser les coûts d'obtention de l'actionneur électromécanique 11.

Ici, les première et deuxième électrodes 30, 31 de l'éclateur 29 sont placées dans un milieu qui est l'air ambiant, en particulier à l'intérieur de l'enveloppe conductrice 17 de l'actionneur électromécanique 11.

Avantageusement, le câble d'alimentation électrique 18 de l'actionneur électromécanique 11 comprend une pluralité de conducteurs électriques. Les conducteurs électriques 25, 26 d'alimentation en énergie électrique du moteur électrique 16 sont reliés électriquement aux conducteurs électriques du câble d'alimentation électrique 18.

Les conducteurs électriques 25, 26 d'alimentation en énergie électrique du moteur électrique 16 peuvent être réalisés au moyen de fils électriques reliant électriquement la plaquette de circuit imprimé 27 au câble d'alimentation électrique 18, comme représenté à la figure 5.

En variante, les conducteurs électriques 25, 26 sont réalisés au moyen de pistes électriques de la plaquette de circuit imprimé 27.

En pratique, les conducteurs électriques du câble d'alimentation électrique 18 sont reliés électriquement aux conducteurs électriques du réseau d'alimentation en énergie électrique.

Ici, le réseau d'alimentation en énergie électrique, le câble d'alimentation électrique 18 de l'actionneur électromécanique 11, ainsi que les conducteurs électriques 25, 26 comprennent au moins un conducteur électrique de neutre et au moins un conducteur de phase.

Dans l'exemple de réalisation illustré aux figures 3 à 5, l'enveloppe conductrice de l'actionneur électromécanique 11 est le carter 17 de l'actionneur électromécanique 11 réalisé dans un matériau métallique, à l'intérieur duquel est logée l'unité électronique de contrôle 15.

En variante, non représentée, l'enveloppe conductrice de l'actionneur électromécanique 11 est réalisée au moyen d'une couche conductrice ménagée sur une surface interne du carter 17 de l'actionneur électromécanique 11, par exemple par une couche de peinture métallisée ou une feuille ayant une face conductrice. Dans un tel cas, le carter 17 de l'actionneur électromécanique 11 peut être réalisé dans une matière plastique.

Avantageusement, l'enveloppe conductrice 17 de l'actionneur électromécanique 11 est reliée électriquement à une masse de référence 35, en particulier le 0 volt de la plaquette de circuit imprimé 27 de l'unité électronique de contrôle 15.

Ici, la décharge des charges électrostatiques est mise en oeuvre par la circulation d'un courant électrique à partir de l'écran 2 jusqu'au réseau d'alimentation en énergie électrique, en passant par le tube d'enroulement 4, l'élément de liaison 22, le carter 17 de l'actionneur électromécanique 11, une languette métallique 33 de liaison entre le carter 17 et la première piste électrique 36 de la plaquette de circuit imprimé 27, l'éclateur 29, la deuxième piste électrique 37 de la plaquette de circuit imprimé 27, le conducteur électrique 25 et un conducteur électrique du câble d'alimentation électrique 18.

La première piste électrique 36 de la plaquette de circuit imprimé 27 comprend au moins la première électrode 30 de l'éclateur 29. En outre, la deuxième piste électrique 37 de la plaquette de circuit imprimé 27 comprend au moins la deuxième électrode 31 de l'éclateur 29.

Dans un exemple de réalisation, la deuxième piste électrique 37 de la plaquette de circuit imprimé 27 peut faire partie de l'un des conducteurs électriques 25, 26 d'alimentation en énergie électrique du moteur électrique 16.

La liaison électrique entre la deuxième piste électrique 37 de la plaquette de circuit imprimé 27 et l'un des conducteurs électriques du câble d'alimentation électrique 18 est mise en oeuvre par l'intermédiaire du conducteur électrique 25 et, éventuellement, un connecteur électrique, non représenté.

Pour permettre la décharge des charges électrostatiques, l'élément de liaison 22 entre le tube d'enroulement 4 et l'arbre de sortie 21 de l'actionneur électromécanique 11 peut être soit recouvert d'une couche en matériau métallique, en particulier d'une feuille pouvant être, par exemple, en aluminium, soit réalisé dans une matière métallique pouvant être, par exemple, du zamak.

En pratique, la languette métallique 33 est fixée sur un support de montage 34 de la plaquette de circuit imprimé 27. Le support de montage 34 est disposé à l'intérieur du carter 17 de l'actionneur électromécanique 11, dans la configuration assemblée de l'actionneur électromécanique 11.

En variante, non représentée, la liaison électrique entre le tube d'enroulement 4 et le carter 17 de l'actionneur électromécanique 11 est mise en oeuvre au moyen d'un accessoire, pouvant être, par exemple, une entretoise.

Dans un exemple de réalisation, la liaison électrique entre la deuxième électrode 31 de l'éclateur 29 et l'un des conducteurs électriques du câble d'alimentation électrique 18 peut comprendre des composants électroniques 38, disposés le long de la deuxième piste électrique 37 de la plaquette de circuit imprimé 27, notamment en fonction du routage de la plaquette de circuit imprimé 27.

Dans un tel cas, les composants électroniques 38 de la plaquette de circuit imprimé 27, qui sont disposés entre la deuxième électrode 31 de l'éclateur 29 et l'un des conducteurs électriques du câble d'alimentation électrique 18, présentent une impédance négligeable vis-à-vis de la charge électrostatique passant au travers de l'éclateur 29.

Ici et comme illustré à la figure 5, la deuxième électrode 31 de l'éclateur 29 est reliée électriquement au conducteur électrique 25 en amont d'un pont de diode 39.

Avantageusement, la deuxième électrode 31 de l'éclateur 29 est reliée électriquement au conducteur électrique 25 par une liaison électrique la plus directe possible et traversant le minimum de composants électroniques.

Ici et de manière nullement limitative, les composants électroniques 38 de la plaquette de circuit imprimé 27 disposés le long de la deuxième piste électrique 37 de la plaquette de circuit imprimé 27comprennent un fusible et une résistance de protection.

En variante, de tels composants électroniques 38 de la plaquette de circuit imprimé 27 peuvent être disposés le long d'une autre piste électrique 40 de la plaquette de circuit imprimé 27 reliée électriquement au conducteur électrique 26.

Préférentiellement, l'actionneur électromécanique 11 est de classe de protection électrique 2. En outre, l'actionneur électromécanique 11 présente une double isolation électrique ou une isolation électrique renforcée.

Ainsi, la double isolation électrique ou l'isolation électrique renforcée permet de garantir qu'aucune partie de l'actionneur électromécanique 11 n'est soumise à une tension dangereuse.

De cette manière, une double isolation électrique ou une isolation électrique renforcée peut permettre de réduire les coûts d'obtention de l'actionneur électromécanique 11, en particulier par rapport à un actionneur électromécanique n'ayant qu'une simple isolation électrique, autrement dit de classe de protection électrique 1, où l'isolation électrique est, par exemple, mise en oeuvre au moyen d'un conducteur électrique de terre relié au carter de l'actionneur réalisé dans un matériau métallique.

En outre, une double isolation électrique ou une isolation électrique renforcée permet de garantir la sécurité lors de l'utilisation de l'actionneur électromécanique 11, en particulier en limitant l'accumulation de charges électrostatiques dans l'enveloppe conductrice 17.

Par ailleurs, une double isolation électrique ou une isolation électrique renforcée permet de simplifier l'architecture de l'actionneur électromécanique 11.

Ici, l'enveloppe conductrice 17 de l'actionneur électromécanique 11 n'est pas reliée électriquement à la terre.

Ainsi, l'actionneur électromécanique 11 peut être relié électriquement au réseau d'alimentation en énergie électrique sans nécessiter un conducteur électrique de terre, tant au niveau de l'actionneur électromécanique 11 que du réseau d'alimentation en énergie électrique, lors de l'installation de l'actionneur électromécanique 11, de sorte à simplifier l'installation de l'actionneur électromécanique 11 et à réduire les coûts d'obtention de l'actionneur électromécanique 11.

Préférentiellement, le conducteur électrique 25 d'alimentation en énergie électrique du moteur électrique 16 relié électriquement à la deuxième électrode 31 de l'éclateur 29 est un conducteur électrique de neutre. Le conducteur électrique 25 d'alimentation en énergie électrique du moteur électrique 16 est configuré pour être relié électriquement à un conducteur électrique du réseau d'alimentation en énergie électrique.

En variante, il peut toutefois s'agir d'un conducteur de phase.

Avantageusement, une première extrémité 30a de la première électrode 30 de l'éclateur 29 est disposée en vis-à-vis d'une première extrémité 31a de la deuxième électrode 31 de l'éclateur 29. La première extrémité 30a de la première électrode 30 est distante de la première extrémité 31a de la deuxième électrode 31 d'un écartement E déterminé.

L'écartement E entre la première extrémité 30a de la première électrode 30 et la première extrémité 31a de la deuxième électrode 31 est déterminé en fonction d'une valeur de ligne de fuite.

Ainsi, l'écartement E permet de garantir la double isolation électrique ou l'isolation électrique renforcée, de respecter les distances d'isolation électrique et d'évacuer les charges électrostatiques à partir d'une valeur seuil de courant électrique.

Ici et de manière nullement limitative, la valeur de l'écartement E est de l'ordre de trois millimètres, de sorte à respecter une ligne de fuite de cinq millimètres.

Avantageusement, la première extrémité 30a, 31a de chacune des première et deuxième électrodes 30, 31 de l'éclateur 29 est en forme de pointe.

Ainsi, la forme de la première extrémité 30a, 31a de chacune des première et deuxième électrodes 30, 31 de l'éclateur 29 permet d'orienter le cheminement du courant électrique traversant l'éclateur 29.

En pratique, la pointe de la première extrémité 30a de la première électrode 30 est disposée en vis-à-vis de la pointe de la première extrémité 31a de la deuxième électrode 31.

Avantageusement, la première extrémité 30a de la première électrode 30 est séparée de la première extrémité 31a de la deuxième électrode 31 par un trou 32 ménagé dans la plaquette de circuit imprimé 27.

Ainsi, le trou 32 ménagé dans la plaquette de circuit imprimé 27 entre la première extrémité 30a de la première électrode 30 et la première extrémité 31a de la deuxième électrode 31 permet de respecter la longueur de ligne de fuite.

Ici, le trou 32 ménagé dans la plaquette de circuit imprimé 27 est traversant.

Avantageusement, le trou 32 ménagé dans la plaquette de circuit imprimé 27 entre la première extrémité 30a de la première électrode 30 et la première extrémité 31a de la deuxième électrode 31 est de forme oblongue.

Ainsi, la forme du trou 32 permet de limiter l'encombrement de l'éclateur 29 au niveau de la plaquette de circuit imprimé 27, en particulier par rapport à un trou de forme ronde.

Grâce à la présente invention, l'évacuation de charges électrostatiques au travers de l'éclateur ménagé au niveau de la plaquette de circuit imprimé de l'unité électronique de contrôle de l'actionneur permet de créer un chemin préférentiel et maîtrisé de décharge entre l'enveloppe conductrice de l'actionneur et l'un des conducteurs électriques d'alimentation en énergie électrique du moteur électrique de l'actionneur.

De cette manière, l'évacuation de charges électrostatiques au travers de l'éclateur ménagé au niveau de la plaquette de circuit imprimé permet d'éviter des dysfonctionnements et/ou des endommagements de l'actionneur et, en particulier, d'empêcher la destruction de composants électroniques montés sur la plaquette de circuit imprimé.

Par conséquent, l'éclateur ménagé au niveau de la plaquette de circuit imprimé permet d'évacuer des charges électrostatiques accumulées dans un écran d'un dispositif d'occultation de l'installation domotique de protection solaire.

De cette manière, l'éclateur ménagé au niveau de la plaquette de circuit imprimé permet de protéger l'unité électronique de contrôle de l'actionneur.

De nombreuses modifications peuvent être apportées aux exemples de réalisation décrits précédemment sans sortir du cadre de l'invention défini par les revendications.

En particulier, le moteur électrique de l'actionneur électromécanique peut être du type asynchrone ou à courant continu.

La présente invention a été décrite en référence à un store à bras motorisé. Néanmoins, celle-ci s'applique également à un dispositif d'occultation pouvant être un store en toile ou avec des lames orientables, ou encore un volet roulant. La présente invention s'applique à tous les types de dispositif d'occultation dont l'actionneur électromécanique tubulaire comprend un dispositif de décharge de charges électrostatiques.

En outre, les modes de réalisation et variantes envisagés peuvent être combinés pour générer de nouveaux modes de réalisation de l'invention, sans sortir du cadre de l'invention défini par les revendications.

## Revendications

1. Actionneur électromécanique tubulaire (11) pour une installation domotique (1) de protection solaire comprenant :
- une enveloppe conductrice (17),
- un moteur électrique (16), le moteur électrique (16) étant alimenté en énergie électrique au moyen de conducteurs électriques (25, 26), les conducteurs électriques (25, 26) étant configurés pour être reliés électriquement à un réseau d'alimentation en énergie électrique,
- une unité électronique de contrôle (15), l'unité électronique de contrôle (15) comprenant une plaquette de circuit imprimé (27) équipée de composants électroniques (38, 39),
- un dispositif de décharge de charges électrostatiques (28), le dispositif de décharge de charges électrostatiques (28) comprenant un éclateur (29) ménagé au niveau de la plaquette de circuit imprimé (27) de l'unité électronique de contrôle (15), l'éclateur (29) comprenant une première et une deuxième électrodes (30, 31) formées respectivement par une première piste conductrice (36) et par une deuxième piste conductrice (37) de la plaquette de circuit imprimé (27), la première électrode (30) étant reliée électriquement à l'enveloppe conductrice (17) de l'actionneur (11) et la deuxième électrode (31) étant reliée électriquement à l'un des conducteurs électriques (25, 26) d'alimentation en énergie électrique du moteur électrique (16).

2. Actionneur électromécanique tubulaire (11) selon la revendication 1, **caractérisé en ce que** le conducteur électrique (25) d'alimentation en énergie électrique du moteur électrique (16) relié électriquement à la deuxième électrode (31) de l'éclateur (29) est un conducteur électrique de neutre ou de phase, le conducteur électrique (25) d'alimentation en énergie électrique du moteur électrique (16) étant configuré pour être relié électriquement à un conducteur électrique du réseau d'alimentation en énergie électrique.

3. Actionneur électromécanique tubulaire (11) selon la revendication 1 ou la revendication 2, **caractérisé en ce qu'**une première extrémité (30a) de la première électrode (30) de l'éclateur (29) est disposée en vis-à-vis d'une première extrémité (31a) de la deuxième électrode (31) de l'éclateur (29), la première extrémité (30a) de la première électrode (30) étant distante de la première extrémité (31a) de la deuxième électrode (31) d'un écartement (E) déterminé.

4. Actionneur électromécanique tubulaire (11) selon la revendication 3, **caractérisé en ce que** la première extrémité (30a, 31a) de chacune des première et deuxième électrodes (30, 31) de l'éclateur (29) est en forme de pointe.

5. Actionneur électromécanique tubulaire (11) selon la revendication 3 ou la revendication 4, **caractérisé en ce que** la première extrémité (30a) de la première électrode (30) est séparée de la première extrémité (31a) de la deuxième électrode (31) par un trou (32) ménagé dans la plaquette de circuit imprimé (27).

6. Actionneur électromécanique tubulaire (11) selon l'une quelconque des revendications 1 à 5, **caractérisé en ce que** l'enveloppe conductrice (17) de l'actionneur électromécanique (11) est reliée électriquement à une masse de référence (35).

7. Actionneur électromécanique tubulaire (11) selon l'une quelconque des revendications 1 à 6, **caractérisé en ce que** l'actionneur électromécanique (11) comprend un câble d'alimentation électrique (18), **en ce que** le câble d'alimentation électrique (18) comprend une pluralité de conducteurs électriques et **en ce que** les conducteurs électriques (25, 26) d'alimentation en énergie électrique du moteur électrique (16) sont reliés électriquement aux conducteurs électriques du câble d'alimentation électrique (18).

8. Actionneur électromécanique tubulaire (11) selon l'une quelconque des revendications 1 à 7, **caractérisé en ce que** l'enveloppe conductrice (17) de l'actionneur (11) est un carter (17) de l'actionneur (11) réalisé dans un matériau métallique, à l'intérieur duquel est logée l'unité électronique de contrôle (15).

9. Actionneur électromécanique tubulaire (11) selon l'une quelconque des revendications 1 à 7, **caractérisé en ce que** l'enveloppe conductrice de l'actionneur (11) est réalisée au moyen d'une couche conductrice ménagée sur une surface interne d'un carter (17) de l'actionneur (11).

10. Installation domotique (1) de protection solaire comprenant un écran (2) enroulable sur un tube d'enroulement (4) entraîné en rotation par un actionneur électromécanique tubulaire (11), **caractérisée en ce que** l'actionneur électromécanique tubulaire (11) est conforme à l'une quelconque des revendications 1 à 9.

## Patentansprüche

1. Rohrförmiger elektromechanischer Aktor (11) für eine Hausanlage (1) zum Sonnenschutz, umfassend:
- eine leitfähige Umhüllung (17),
- einen Elektromotor (16), wobei der Elektromotor (16) mittels elektrischer Leiter (25, 26) mit Strom versorgt wird, wobei die elektrischen Leiter (25, 26) dazu ausgelegt sind, elektrisch mit einem Stromversorgungsnetz verbunden zu werden,
- eine elektronische Steuereinheit (15), wobei die elektronische Steuereinheit (15) eine Leiterplatte (27) umfasst, die mit elektronischen Komponenten (38, 39) bestückt ist,
- eine Vorrichtung zum Entladen elektrostatischer Aufladungen (28), wobei die Vorrichtung zum Entladen elektrostatischer Aufladungen (28) eine Funkenstrecke (29) umfasst, die auf Höhe der Leiterplatte (27) der elektronischen Steuereinheit (15) vorgesehen ist, wobei die Funkenstrecke (29) eine erste und eine zweite Elektrode (30, 31) umfasst, die jeweils durch eine erste Leiterbahn (36) und durch eine zweite Leiterbahn (37) der Leiterplatte (27) gebildet sind, wobei die erste Elektrode (30) elektrisch mit der leitfähigen Umhüllung (17) des Aktors (11) und die zweite Elektrode (31) elektrisch mit einem der elektrischen Leiter (25, 26) zur Stromversorgung des Elektromotors (16) verbunden ist.

2. Rohrförmiger elektromechanischer Aktor (11) nach Anspruch 1, **dadurch gekennzeichnet, dass** der elektrische Leiter (25) zur Stromversorgung des Elektromotors (16), der elektrisch mit der zweiten Elektrode (31) der Funkenstrecke (29) verbunden ist, ein elektrischer Neutral- oder Phasenleiter ist, wobei der elektrische Leiter (25) zur Stromversorgung des Elektromotors (16) dazu ausgelegt ist, elektrisch mit einem elektrischen Leiter des Stromversorgungsnetzes verbunden zu werden.

3. Rohrförmiger elektromechanischer Aktor (11) nach Anspruch 1 oder Anspruch 2, **dadurch gekennzeichnet, dass** ein erstes Ende (30a) der ersten Elektrode (30) der Funkenstrecke (29) gegenüber einem ersten Ende (31a) der zweiten Elektrode (31) der Funkenstrecke (29) angeordnet ist, wobei das erste Ende (30a) der ersten Elektrode (30) in einem bestimmten Abstand (E) von dem ersten Ende (31a) der zweiten Elektrode (31) angeordnet ist.

4. Rohrförmiger elektromechanischer Aktor (11) nach Anspruch 3, **dadurch gekennzeichnet, dass** das erste Ende (30a, 31a) jeder der ersten und zweiten Elektroden (30, 31) der Funkenstrecke (29) spitz zuläuft.

5. Rohrförmiger elektromechanischer Aktor (11) nach Anspruch 3 oder Anspruch 4, **dadurch gekennzeichnet, dass** das erste Ende (30a) der ersten Elektrode (30) vom ersten Ende (31a) der zweiten Elektrode (31) durch ein in der Leiterplatte (27) ausgebildetes Loch (32) getrennt ist.

6. Rohrförmiger elektromechanischer Aktor (11) nach einem der Ansprüche 1 bis 5, **dadurch gekennzeichnet, dass** die leitfähige Umhüllung (17) des elektromechanischen Aktors (11) elektrisch mit einer Bezugsmasse (35) verbunden ist.

7. Rohrförmiger elektromechanischer Aktor (11) nach einem der Ansprüche 1 bis 6, **dadurch gekennzeichnet, dass** der elektromechanische Aktor (11) ein Stromversorgungskabel (18) umfasst, dass das Stromversorgungskabel (18) eine Vielzahl elektrischer Leiter umfasst und dass die elektrischen Leiter (25, 26) zur Stromversorgung des Elektromotors (16) elektrisch mit den elektrischen Leitern des Stromversorgungskabels (18) verbunden sind.

8. Rohrförmiger elektromechanischer Aktor (11) nach einem der Ansprüche 1 bis 7, **dadurch gekennzeichnet, dass** die leitfähige Umhüllung (17) des Aktors (11) ein Gehäuse (17) des Aktors (11) ist, das aus einem metallischen Material gebildet ist, in dessen Innerem die elektronische Steuereinheit (15) untergebracht ist.

9. Rohrförmiger elektromechanischer Aktor (11) nach einem der Ansprüche 1 bis 7, **dadurch gekennzeichnet, dass** die leitfähige Umhüllung des Aktors (11) mittels einer Leiterschicht, die auf einer Innenfläche eines Gehäuses (17) des Aktors (11) ausgebildet ist, verwirklicht ist.

10. Hausanlage (1) zum Sonnenschutz, umfassend eine Schutzabdeckung (2), die auf ein Aufwickelrohr (4) aufwickelbar ist, das durch einen rohrförmigen elektromechanischen Aktor (11) in Drehung versetzt wird, **dadurch gekennzeichnet, dass** der rohrförmige elektromechanische Aktor (11) gemäß einem der Ansprüche 1 bis 9 ausgebildet ist.

## Claims

1. Tubular electromechanical actuator (11) for a home-automation facility (1) for solar protection, comprising:
- a conductive enclosure (17),
- an electric motor (16), the electric motor (16) being supplied with electrical energy by means of electrical conductors (25, 26), the electrical conductors (25, 26) being configured to be electrically connected to an electrical energy supply network,
- an electronic control unit (15), the electronic control unit (15) comprising a printed circuit board (27) equipped with electronic components (38, 39),
- a device for discharging electrostatic charges (28),
the device for discharging electrostatic charges (28) comprising
a spark gap (29) arranged on the printed circuit board (27) of the electronic control unit (15), the spark gap (29) comprising a first and a second electrode (30, 31) formed, respectively, by a first conductive track (36) and by a second conductive track (37) of the printed circuit board (27), the first electrode (30) being electrically connected to the conductive enclosure (17) of the actuator (11) and the second electrode (31) being electrically connected to one of the electrical conductors (25, 26) supplying electrical energy to the electric motor (16).

2. Tubular electromechanical actuator (11) according to Claim 1, **characterized in that** the electrical conductor (25) supplying electrical energy to the electric motor (16) electrically connected to the second electrode (31) of the spark gap (29) is a neutral or phase conductor, the electrical conductor (25) supplying electrical energy to the electric motor (16) being configured to be electrically connected to an electrical conductor of the electrical energy supply network.

3. Tubular electromechanical actuator (11) according to Claim 1 or Claim 2, **characterized in that** a first end (30a) of the first electrode (30) of the spark gap (29) is positioned facing a first end (31a) of the second electrode (31) of the spark gap (29), the first end (30a) of the first electrode (30) being separated from the first end (31a) of the second electrode (31) by a specified spacing (E).

4. Tubular electromechanical actuator (11) according to Claim 3, **characterized in that** the first end (30a, 31a) of each of the first and second electrodes (30, 31) of the spark gap (29) is in the form of a point.

5. Tubular electromechanical actuator (11) according to Claim 3 or Claim 4, **characterized in that** the first end (30a) of the first electrode (30) is separated from the first end (31a) of the second electrode (31) by a hole (32) formed in the printed circuit board (27).

6. Tubular electromechanical actuator (11) according to any of Claims 1 to 5, **characterized in that** the conductive enclosure (17) of the electromechanical actuator (11) is electrically connected to a reference earth (35).

7. Tubular electromechanical actuator (11) according to any of Claims 1 to 6, **characterized in that** the electromechanical actuator (11) comprises an electrical power supply cable (18), **in that** this electrical power supply cable (18) comprises a plurality of electrical conductors and **in that** the electrical conductors (25, 26) supplying electrical energy to the electric motor (16) are electrically connected to the electrical conductors of the electrical power supply cable (18).

8. Tubular electromechanical actuator (11) according to any of Claims 1 to 7, **characterized in that** the conductive enclosure (17) of the actuator (11) is a housing (17) of the actuator (11) made of a metallic material, inside which the electronic control unit (15) is housed.

9. Tubular electromechanical actuator (11) according to any of Claims 1 to 7, **characterized in that** the conductive enclosure of the actuator (11) is made in the form of a conductive layer arranged on an inner surface of a housing (17) of the actuator (11).

10. Home-automation facilty (1) for solar protection, comprising a screen (2) that can be wound on to a winding tube (4) driven in rotation by a tubular electromechanical actuator (11), **characterized in that** the tubular electromechanical actuator (11) is in accordance with any of Claims 1 to 9.
